(19) Europäisches Patentamt / European Patent Office / Office européen des brevets

(11) **EP 3 214 634 B1**

(12) **EUROPEAN PATENT SPECIFICATION**

(45) Date of publication and mention
of the grant of the patent:
**20.03.2019   Bulletin 2019/12**

(21) Application number: **14904741.7**

(22) Date of filing: **29.10.2014**

(51) Int Cl.:
***H01H 83/02*** (2006.01)          *G05F 1/618* (2006.01)
***H02H 1/06*** (2006.01)

(86) International application number:
**PCT/JP2014/078720**

(87) International publication number:
**WO 2016/067378 (06.05.2016 Gazette 2016/18)**

(54) **EARTH LEAKAGE CIRCUIT BREAKER**

FEHLERSTROM-SCHUTZSCHALTER

DISJONCTEUR DE FUITE À LA TERRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**06.09.2017   Bulletin 2017/36**

(73) Proprietor: **Mitsubishi Electric Corporation
Chiyoda-ku
Tokyo 100-8310 (JP)**

(72) Inventors:
• **CHIKAI, Masataka
  Tokyo 102-0073 (JP)**
• **TSUKAMOTO, Tatsuyuki
  Tokyo 102-0073 (JP)**

(74) Representative: **Diehl & Partner GbR
Patentanwälte
Erika-Mann-Strasse 9
80636 München (DE)**

(56) References cited:
**EP-A1- 2 051 359          CN-A- 101 540 249
JP-A- H0 863 242          JP-A- H07 326 278
JP-A- 2009 095 125      KR-A- 20130 099 787**

**Description**

TECHNICAL FIELD

The present invention relates to an earth leakage breaker which opens an electric path when leakage current of the electric path has reached a predetermined value or higher. In particular, the present invention relates to an operation power supply for the earth leakage breaker.

BACKGROUND ART

The power supply circuit included in this type of earth leakage breaker converts, through a rectification circuit, AC voltage (for example, AC100V) supplied from an AC electric path into DC voltage, and then converts through a step-down circuit the rectified DC voltage into lower voltage (for example, DC24V), thereby providing a driving power supply to an earth leakage detection circuit and a tripping device.

In such a power supply circuit, the earth leakage detection circuit and the tripping device need to be protected from surge voltage caused by arcing ground, lightning, or the like in the AC electric path, and from momentary or intermittent surge voltage (for example, several kilovolts) such as switching surge caused by switching of an electromagnetic contactor or a relay.

As a protection means therefor, a power supply circuit is known (for example, see Patent Document 1) that is provided with: a voltage detection circuit for detecting surge voltage from the output voltage of a rectification circuit; a step-up circuit for stepping up the output voltage of a step-down circuit when this voltage detection circuit has detected surge voltage; and a current absorption circuit provided on the output side of the step-down circuit and for absorbing surge current when the output voltage of the step-down circuit has reached a predetermined value.

Another protection means against surge voltage includes overvoltage absorption means provided between a rectification circuit and a step-down circuit. More specifically, an overvoltage detection circuit for detecting, by using a Zener diode, surge voltage that has entered an AC circuit is provided, and a series unit composed of a thyristor and a capacitor is connected in parallel to both ends of the input portion of a step-down circuit. When the overvoltage detection circuit has detected surge voltage, the thyristor is turned on, thereby causing the capacitor to absorb the surge voltage (for example, see Patent Document 2).

EP 2 051 359 A1 discloses an earth leakage circuit breaker comprising a step-down transforming means and a current absorbing means for absorbing a surge current, the current absorbing means being provided on the output side of the step-down transforming means.

CN 101 540 249 A discloses an earth leakage circuit breaker with a current absorbing means in form of a Zener diode provided at the output of the step-down circuit.

KR 2013 0099787 A discloses an earth leakage breaker circuit with a current absorbing means formed by a Zener diode located at the output of the step-down circuit.

JP H07 326278 A discloses an earth leakage breaker circuit without a current absorbing means.

CITATION LIST

PATENT DOCUMENT

Patent Document 1: Japanese Laid-Open Patent Publication No. 2009-95125 (FIG. 1)
Patent Document 2: Japanese Laid-Open Patent Publication No. 2009-195033 (FIG. 5)

SUMMARY OF THE INVENTION

PROBLEMS TO BE SOLVED BY THE INVENTION

In the power supply circuit of such a conventional earth leakage breaker, when surge voltage is induced, the output voltage of the step-down circuit is stepped up by the step-up circuit, and the current is caused to pass through the current absorption circuit which absorbs the surge current when the output voltage of the step-down circuit has reached a predetermined value, whereby the voltage is clamped to a constant voltage, thereby preventing components of the earth leakage detection circuit from failing due to overvoltage. In this case, since the surge is bypassed by a MOS-FET forming the step-down circuit, there is a problem that a large-sized MOS-FET having large allowable dissipation is necessary.

It is also conceivable to provide protection means described in Patent Document 2 between the step-down circuit and the rectification circuit described in Patent Document 1. However, when surge voltage is applied, the thyristor bypasses the surge, and thus, almost all the surge voltage is borne by an input resistor provided on the AC electric path side relative to the rectification circuit. Thus, the output voltage of the rectification circuit being the voltage between the anode and the cathode of the thyristor becomes equal to the ON-voltage (for example, 2V) of the thyristor, and the voltage between the gate and the source of the MOS-FET becomes less than or equal to the gate-threshold voltage (for example, 4V) of the MOS-FET. Then, the output voltage of the step-down circuit is reduced to 0V, for example, thus becoming unable to drive the tripping device, which poses a problem that the function as an earth leakage breaker may be lost.

The present invention has been made in order to solve the above problem. An object of the present invention is to enable use of a MOS-FET whose maximum allowable dissipation is small, and to downsize an earth leakage breaker.

SOLUTION TO THE PROBLEMS

The present invention includes: a switching contact for switching an electric path; a leakage current detector for detecting leakage current of the electric path; a power supply circuit for stepping down power supplied from the electric path into power of low voltage; an earth leakage detection circuit supplied with power by the power supply circuit and for detecting earth leakage on the basis of a detection signal of the leakage current detector; a tripping device driven by the earth leakage detection circuit to open the switching contact; a surge absorption circuit being composed of a switching element and a first Zener diode connected in series to the switching element such that the anode of the Zener diode is connected to the negative input terminal of the step-down circuit and the other end of the surge absorption circuit is connected to the positive input terminal of the step-down circuit, the switching element comprising a gate connected to a voltage divider circuit such, that the switching element becomes conductive, when the input voltage of the step-down circuit reaches a predetermined value.

EFFECT OF THE INVENTION

According to the present invention, surge voltage superimposed on the electric path is bypassed by the series unit composed of the switching element and the first Zener diode provided on the input side of the step-down circuit. Thus, a component whose maximum allowable dissipation is small and whose outer shape is small can be used for the step-down circuit, and thus, the earth leakage breaker can be downsized.

BRIEF DESCRIPTION OF THE DRAWINGS

[FIG. 1] FIG. 1 is a circuit diagram showing a configuration of an earth leakage breaker using a power supply circuit in embodiment 1 of the present invention.
[FIG. 2] FIG. 2 is a circuit diagram showing a configuration of an earth leakage breaker using a power supply circuit in embodiment 2 of the present invention.
[FIG. 3] FIG. 3 is a circuit diagram showing a configuration of a DC earth leakage breaker using a power supply circuit in embodiment 3 of the present invention.
[FIG. 4] FIG. 4 is a circuit diagram showing a configuration of a DC earth leakage breaker using a power supply circuit in embodiment 4 of the present invention.

DESCRIPTION OF EMBODIMENTS

Embodiment 1

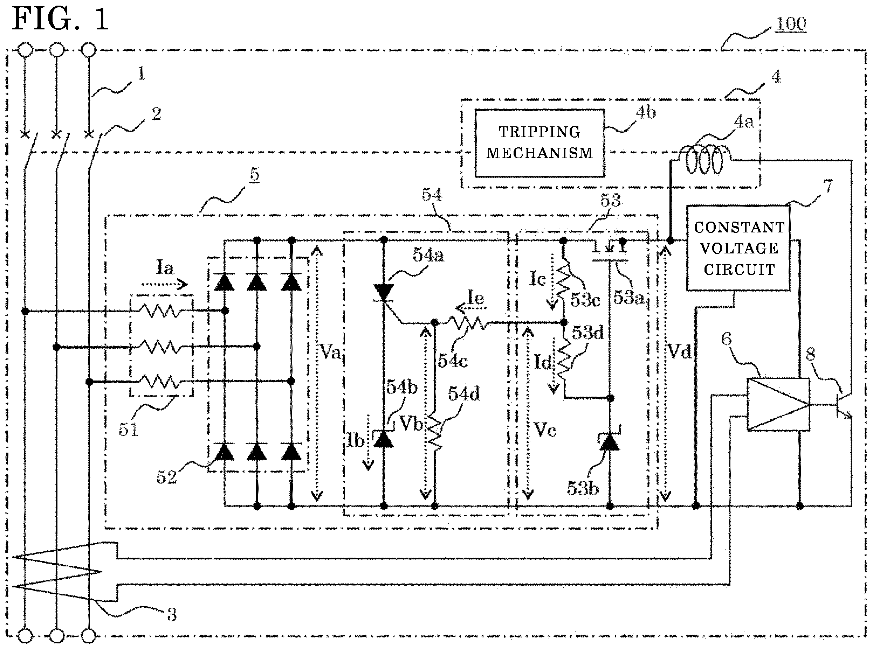

FIG. 1 is a circuit diagram showing a configuration of an earth leakage breaker using a power supply circuit in embodiment 1 of the present invention.
In FIG. 1, an earth leakage breaker 100 has: a switching contact 2 for switching an AC electric path 1; an earth leakage detection circuit 6 connected to a zero-phase current transformer 3 inserted in the AC electric path 1 and for detecting earth leakage on the basis of a detection signal of the zero-phase current transformer 3; a tripping device 4 which has a tripping coil 4a to be energized via a transistor 8 on the basis of an output signal of the earth leakage detection circuit 6, and a tripping mechanism 4b driven to open the switching contact 2 when the tripping coil 4a is energized; and a power supply circuit 5 for feeding power to both of the earth leakage detection circuit 6 and the tripping device 4.

The power supply circuit 5 converts AC voltage inputted from the AC electric path 1 into predetermined DC voltage to supply excitation current to the tripping coil 4a, and a constant voltage circuit 7 converts the output voltage of the power supply circuit 5 into predetermined voltage which is lower than the output voltage of the power supply circuit 5, and supplies the predetermined voltage to the earth leakage detection circuit 6.

The power supply circuit 5 will be described in detail below.

The power supply circuit 5 has: a current limiting circuit 51, i.e., a resistor, connected to the AC electric path 1 and for limiting current from the AC electric path 1; a rectification circuit 52 connected to the current limiting circuit 51 in a subsequent stage thereof, and for converting AC voltage into DC voltage through diode bridge; a step-down circuit 53 provided to the output side of the rectification circuit 52 and for stepping down the DC voltage from the rectification circuit 52 into lower DC voltage; and a surge absorption circuit 54 provided between the rectification circuit 52 and the step-down circuit 53 and for absorbing surge voltage from the AC electric path 1.

The step-down circuit 53 is composed of: a field-effect transistor 53a (hereinafter, FET) whose drain is connected to the positive terminal of the output of the rectification circuit 52; a second Zener diode 53b whose cathode is connected to the gate of the FET 53a and whose anode is connected to the negative terminal of the output of the rectification circuit 52; a first resistor 53c whose one end is connected to the drain of the FET 53a; and a second resistor 53d whose one end is connected to the other end of the first resistor 53c, and whose other end is connected to the cathode of the second Zener diode 53b.

The surge absorption circuit 54 is composed of: a thyristor 54a, i.e., a switching element, whose anode is connected to the connection point between the drain of the FET 53a and the positive terminal of the output of the rectification circuit 52; a first Zener diode 54b whose cathode is connected to the cathode of the thyristor 54a and whose anode is connected to the negative terminal of the output of the rectification circuit 52; a third resistor 54c whose one end is connected to the gate of the thyristor 54a and whose other end is connected to the connection point between the first resistor 53c and the second resistor 53d; and a fourth resistor 54d whose one end is connected to the gate of the thyristor 54a and whose other end is connected to the anode of the first Zener diode 54b.

Although the thyristor 54a is provided on the positive side of the output of the rectification circuit 52, and the first Zener diode 54b is provided on the negative side of the output of the rectification circuit 52, the first Zener diode 54b may be provided on the positive side of the output of the rectification circuit 52, and the thyristor 54a may be provided on the negative side of the output of the rectification circuit. In such a case, means for detecting surge voltage is the thyristor 54a only.

Not limited thereto, the thyristor 54a can be formed by a switching element such as a MOSFET, an IGBT, or a bipolar transistor, for example.

In the example, the tripping coil 4a and the transistor 8 are connected to the output of the step-down circuit 53, but may be connected to the output of the rectification circuit 52.

Next, operation will be described.

First, a case of a normal state where no surge voltage is applied will be described.

When AC voltage (for example, about AC100V to 440V) is supplied from the AC electric path 1, AC current Ia flows into the current limiting circuit 51, and is converted into DC voltage Va by the rectification circuit 52.

As for the DC voltage Va, the DC voltage Va of the output from the rectification circuit 52 is divided by the first resistor 53c, the second resistor 53d, and the second Zener diode 53b which are connected in series. Then, the voltage across both ends of the series unit composed of the second resistor 53d and the second Zener diode 53b is defined as voltage Vc.

Then, the gate applied voltage Vb applied to the gate of the thyristor 54a is obtained as the voltage across both ends of the fourth resistor 54d which is obtained by further dividing the voltage Vc by the third resistor 54c and the fourth resistor 54d.

For the thyristor 54a to be turned ON, it is necessary to satisfy

$$Vb > \text{(Zener voltage of the first Zener diode 54b)} + \text{(gate trigger voltage of the thyristor 54a)} \qquad (1).$$

Here, the value of the gate applied voltage Vb satisfying Expression (1) can be obtained by the following Expression (2). Rf is the resistance value of the fourth resistor 54d, and Ie is the current flowing in the third resistor 54c and the fourth resistor 54d.

$$Vb = Rf \times Ie \qquad (2)$$

Further, the current Ie to be substituted into Expression (2) can be obtained by solving three variables simultaneous equations composed of Expression (3) to Expression (5) shown below.

$$Ic = Id + Ie \qquad (3)$$

$$Va-Vz = Rc \times Ic+Rd \times Id \qquad (4)$$

$$Va = (Re+Rf) \times Ie+Rc \times Ic \qquad (5)$$

Here, Ic is the current flowing in the first resistor 53c, Id is the current flowing in the second resistor 53d, and Vz is the Zener voltage of the second Zener diode 53b.

Now, for example, it is assumed that: when the output voltage of the AC electric path 1 is AC 440V, the maximum value of the DC voltage Va of the output of the rectification circuit 52 is about 622V; the Zener voltage Vz of the second Zener diode 53b is 20V; the resistance value Rc of the first resistor 53c is 1.8 M$\Omega$ ; the resistance value Rd of the second resistor 53d is 83 k$\Omega$ ; the resistance value Re of the third resistor 54c is 5.6 k$\Omega$ ; and the resistance value Rf of the fourth resistor 54d is 51 k$\Omega$. Then, when these are substituted into Expression (3) to Expression (5),

$$Ic = Id+Ie \qquad (3')$$

$$622-20 = 1.8 \times 10^{6} \times Ic+83 \times 10^{3} \times Ie \qquad (4')$$

$$622 = (5.6 \times 10^{3}+51 \times 10^{3}) \times Ie+1.8 \times 10^{6} \times Ic \qquad (5')$$

are obtained. Then, the three variables simultaneous equations of (3') to (5') are solved with respect to Ie, Ie = 0.34 mA is obtained. Further, when this value of Ie is substituted into Expression (2),

$$Vb = 51 \times 10^{3} \times 0.34 \times 10^{-3} = 17.5V$$

is obtained.

At this time, if the gate trigger voltage of the thyristor 54a is 2V, the voltage at which the thyristor 54a is turned ON is voltage = 2V+20V = 22V. Since the gate applied voltage Vb (17.5V) is lower than 22V, the gate applied voltage Vb of the thyristor 54a does not reach the electric potential at which the thyristor 54a is turned ON, and conduction between the anode and the cathode of the thyristor 54a is not established.

Meanwhile, due to the DC voltage Va, via the first resistor 53c and the second resistor 53d, the current Id flows to the second Zener diode 53b. Accordingly, the gate voltage of the FET 53a becomes the Zener voltage of the second Zener diode 53b. If the gate-threshold voltage of the FET 53a is taken into consideration, the voltage Vd of the output of the step-down circuit 53 is

$$Vd \fallingdotseq (Zener\ voltage\ of\ the\ second\ Zener\ diode$$
$$53b)-(Gate\text{-}threshold\ voltage\ of\ the\ FET\ 53a).$$

Here, if it is assumed that the Zener voltage of the second Zener diode 53b is 20V and the gate-threshold voltage of the FET 53a is 5V, the voltage Vc of the output of the power supply circuit is Vc $\fallingdotseq$ 20-5 = 15V.

The voltage Vd of the output of the power supply circuit 5 causes power (for example, 15V) to be supplied to the tripping coil 4a and the constant voltage circuit 7, and the constant voltage circuit 7 steps down the output voltage of the power supply circuit 5 to feed predetermined constant voltage (for example, DC5V) to the earth leakage detection circuit 6.

In such a feeding state, when earth leakage has occurred in the AC electric path 1, a signal occurs in the output of the zero-phase current transformer 3, and the earth leakage detection circuit 6 determines that the level of the output signal of the zero-phase current transformer 3 has exceeded a predetermined reference value, and outputs an earth leakage trip signal to the transistor 8. This output causes the transistor 8 to be turned ON, excitation current flows from the power supply circuit 5 via the transistor 8 to the tripping coil 4a, and the tripping mechanism 4b operates, whereby the switching contact 2 is opened.

Next, a case in which surge voltage is superimposed on the AC electric path 1 will be described.

When surge voltage (for example, several kilovolts) is superimposed on AC voltage, surge voltage rectified into the DC voltage Va by the rectification circuit 52 appears. The DC voltage Va of the rectification circuit 52 is divided by the first resistor 53c, the second resistor 53d, and the second Zener diode 53b which are connected in series. Then, the voltage across both ends of the series unit composed of the second resistor 53d and the second Zener diode 53b is defined as the voltage Vc. The gate applied voltage Vb applied to the gate of the thyristor 54a is the voltage across both ends of the fourth resistor 54d obtained by further dividing the voltage Vc by the third resistor 54c and the fourth resistor 54d.

When surge voltage 1 kV is applied to the AC electric path 1, the maximum value of the DC voltage Va of the output of the rectification circuit 52 is about 1 kV. When these are substituted into Expression (3) to Expression (5),

$$\mathrm{Ic\ =\ Id+Ie \quad (3'')}$$

$$\mathrm{1000-20\ =\ 1.8 \times 10^{6} \times Ic+83 \times 10^{3} \times Ie \quad (4'')}$$

$$\mathrm{1000\ =\ (5.6 \times 10^{3}+51 \times 10^{3}) \times Ie+1.8 \times 10^{6} \times Ic \quad (5'')}$$

are obtained.

When the three variables simultaneous equations shown in (3") to (5") are solved with respect to Ie, Ie = 0.46 mA is obtained. When this value of Ie is substituted into Expression (2),

$$\mathrm{Vb\ =\ 51 \times 10^{3} \times 0.46 \times 10^{-3}\ =\ 23.7V}$$

is obtained.

At this time, if the gate trigger voltage of the thyristor 54a is 2V, the voltage at which the thyristor 54a is turned ON is voltage = 2V+20V = 22V. Since the gate applied voltage Vb (23.7V) is higher than 22V, the gate applied voltage Vb of the thyristor 54a reaches the electric potential at which the thyristor 54a is turned ON. Thus, conduction between the anode and the cathode of the thyristor 54a is established.

The DC voltage Va of the output of the rectification circuit 52 in the turned-ON state of the thyristor 54a is kept constant as:

$$\mathrm{Va\ =\ Gate\text{-}threshold\ voltage\ of\ the\ thyristor\ 54a\ +}$$

$$\mathrm{Zener\ voltage\ of\ the\ first\ Zener\ diode\ 54b.}$$

Since the ON-voltage of the thyristor 54a is 2V, and the Zener voltage of the first Zener diode 54b is 20V, Va = 2+20 = 22V is obtained. Due to the DC voltage Va, via the first resistor 53c and the second resistor 53d, the current Id flows to the second Zener diode 53b. Accordingly, the gate voltage of the FET 53a becomes the Zener voltage of the second Zener diode 53b. If the ON-voltage of the FET 53a is taken into consideration, the voltage Vd of the output of the step-down circuit 53 is

$$\mathrm{Vd\ \fallingdotseq\ (Zener\ voltage\ of\ the\ second\ Zener\ diode}$$

$$\mathrm{53b)-(Gate\text{-}threshold\ voltage\ of\ the\ FET\ 53a).}$$

Here, since the Zener voltage of the second Zener diode 53b is 20V and the gate-threshold voltage of the FET 53a is 5V, the voltage Vc of the output of the step-down circuit 53 is Vc ≒ 20-5 = 15V.

As described above, even in the turned-ON state of the thyristor 54a, the voltage Vd of the output of the step-down circuit 53 can cause power (for example, 15V) to be supplied to the tripping coil 4a and the constant voltage circuit 7, and the constant voltage circuit 7 can step down the output voltage of the power supply circuit 5 to feed predetermined constant voltage (for example, DC5V) to the earth leakage detection circuit 6.

Therefore, even if earth leakage occurs in the AC electric path 1 when surge voltage has been superimposed on the AC electric path 1 and the thyristor 54a of the surge absorption circuit 54 has become conductive and is absorbing the surge voltage, determination regarding a signal occurring at the output of the zero-phase current transformer 3 is performed by the earth leakage detection circuit 6. If the value of the signal exceeds a predetermined reference value, the earth leakage detection circuit 6 outputs an earth leakage trip signal to the transistor 8. This output causes the transistor 8 to be turned ON, excitation current flows from the power supply circuit 5 via the transistor 8 to the tripping coil 4a, and the tripping mechanism 4b operates, whereby, the switching contact 2 can be opened.

After the thyristor 54a has become conductive and the surge absorption circuit 54 has absorbed surge voltage, if the DC voltage Va of the output of the rectification circuit 52 becomes less than or equal to the Zener voltage (for example, 20V) of the first Zener diode 54b, current Ib flowing in the first Zener diode 54b becomes less than or equal to the turn-OFF current of the thyristor 54a (for example, several microamperes). Thus, the thyristor 54a is turned OFF and becomes nonconductive.

According to the present embodiment, the earth leakage breaker includes: the earth leakage detection circuit 6 supplied with power by the step-down circuit 53 and for detecting earth leakage on the basis of a detection signal of the zero-phase current transformer 3; the tripping device 4 supplied with power by the step-down circuit 53 and driven by the earth leakage detection circuit 6 to open the switching contact; the thyristor 54a provided in the line on the input side of the step-down circuit 53 and becoming conductive when the input voltage of the step-down circuit 53 reaches a predetermined value; and the first Zener diode 54b provided, with the cathode thereof facing the positive side of the step-down circuit 53, the first Zener diode 54b forming a series unit with the thyristor 54a, and surge voltage superimposed on the AC electric path 1 is bypassed by the series unit composed of the thyristor 54a and the first Zener diode 54b. Thus, it is possible to use an FET which forms the step-down circuit 53, whose maximum allowable dissipation is small, and whose outer shape is small. Thus, it is possible to downsize the earth leakage breaker.

When surge voltage is superimposed on the AC electric path 1, the surge voltage is bypassed by the series unit composed of the thyristor 54a and the first Zener diode 54b, and even when the thyristor 54a is turned ON, the output voltage of the step-down circuit 53 is maintained. This allows the earth leakage detection circuit 6 and the tripping device 4 to operate.

As for the first Zener diode 54b for surge voltage detection, the first Zener diode 54b having low Zener voltage can be used to configure the circuit. Thus, the earth leakage breaker can be downsized.

Embodiment 2

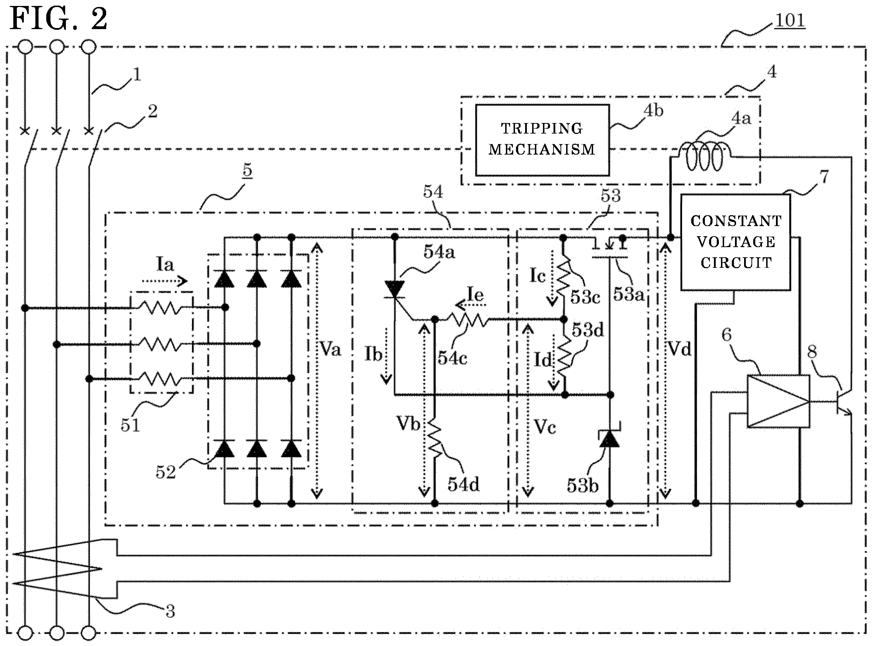

FIG. 2 is a circuit diagram showing a configuration of an earth leakage breaker using a power supply circuit in embodiment 2 of the present invention.

In an earth leakage breaker 101 of the present embodiment, the first Zener diode 54b in embodiment 1 is omitted, and the second Zener diode 53b is used also as the omitted first Zener diode 54b. The earth leakage breaker 101 can exhibit various effects similar to those in embodiment 1.

With reference to FIG. 2, in the power supply circuit 5 in the earth leakage breaker 101, since the first Zener diode 54b used in embodiment 1 is omitted, the cathode of the thyristor 54a is connected to the connection point between the second resistor 53d and the second Zener diode 53b. The other configurations are the same as those in embodiment 1, and thus, detailed description thereof is omitted.

Next, operation will be described.

First, a case of a normal state where no surge voltage is applied will be described.

When AC voltage (for example, about AC100V to 440V) is supplied from the AC electric path 1, the AC current Ia flows into the current limiting circuit 51, and is converted into the DC voltage Va by the rectification circuit 52.

As for the DC voltage Va, the DC voltage Va from the rectification circuit 52 is divided by the first resistor 53c, the second resistor 53d, and the second Zener diode 53b which are connected in series. The voltage across both ends of the series unit composed of the second resistor 53d and the second Zener diode 53b is defined as the voltage Vc.

Then, the gate applied voltage Vb applied to the gate of the thyristor 54a is obtained as the voltage across both ends of the fourth resistor 54d which is obtained by further dividing the voltage Vc by the third resistor 54c and the fourth resistor 54d.

Meanwhile, in order for the thyristor 54a to be turned ON, since the cathode of the thyristor 54a is connected to the connection point between the second resistor 53d and the second Zener diode 53b, it is necessary to satisfy the following Expression (6)

$$Vb > (Zener\ voltage\ of\ the\ second\ Zener\ diode$$

$$53b)+(Gate\ trigger\ voltage\ of\ the\ thyristor\ 54a)\quad(6).$$

Here, the value of the gate applied voltage Vb satisfying Expression (6) can be obtained by: solving, as in embodiment 1, three variables simultaneous equations composed of Expression (3) to Expression (5) to obtain the current Ie; and then substituting this value of Ie into Expression (2).

As in embodiment 1, it is assumed that the resistance value Rc of the first resistor 53c is 1.8 MΩ, the resistance value Rd of the second resistor 53d is 83 kΩ, the resistance value Re of the third resistor 54c is 5.6 kΩ, the resistance value Rf of the fourth resistor 54d is 51 kΩ, and the Zener voltage of the second Zener diode 53b is 20V.

As in embodiment 1, the current Ie is Ie = 0.34 mA. When this value of Ie is substituted into Expression (2),

$$Vb\ =\ 51 \times 10^{3} \times 0.34 \times 10^{-3}\ =\ 17.5V$$

is obtained.

At this time, if the gate trigger voltage of the thyristor 54a is 2V, the voltage at which the thyristor 54a is turned ON is voltage = 2V+20V = 22V. Since the gate applied voltage Vb (17.5V) is lower than 22V, the gate applied voltage Vb of the thyristor 54a does not reach the electric potential at which the thyristor 54a is turned ON. Thus, conduction between the anode and the cathode of the thyristor 54a is not established.

Next, a case in which surge voltage is superimposed on the AC electric path 1 will be described.

When surge voltage (for example, 1kV) is superimposed on AC voltage, Ie = 0.46 mA is obtained as in embodiment 1. When the obtain value of Ie is substituted into Expression (2),

$$Vb\ =\ 51 \times 10^{3} \times 0.46 \times 10^{-3}\ =\ 23.7V$$

is obtained.

At this time, if the gate trigger voltage of the thyristor 54a is 2V, the voltage at which the thyristor 54a is turned ON is voltage = 2V+20V = 22V. Since the gate applied voltage Vb (23.7V) is higher than 23.7V, the gate applied voltage Vb of the thyristor 54a reaches the electric potential at which the thyristor 54a is turned ON. Thus, conduction between the anode and the cathode of the thyristor 54a is established.

After the thyristor 54a has become conductive and the surge absorption circuit 54 has absorbed surge voltage, if the DC voltage Va of the output of the rectification circuit 52 becomes less than or equal to the Zener voltage (for example, 20V) of the second Zener diode 53b, the current Ib flowing in the second Zener diode 53b becomes less than or equal to the turn-OFF current of the thyristor 54a (for example, several microamperes). Thus, the thyristor 54a is turned OFF and becomes nonconductive.

The other operations are the same as those in embodiment 1, and thus, description thereof is omitted.

According to the present embodiment, the earth leakage breaker includes: the earth leakage detection circuit 6 supplied with power by the step-down circuit 53 and for detecting earth leakage on the basis of a detection signal of the zero-phase current transformer 3; the tripping device 4 supplied with power by the step-down circuit 53 and driven by the earth leakage detection circuit 6 to open the switching contact; the thyristor 54a provided in the line on the input side of the step-down circuit 53 and becoming conductive when the input voltage of the step-down circuit 53 reaches a predetermined value; and the second Zener diode 53b provided, with the cathode thereof facing the positive side of the step-down circuit 53, the second Zener diode 53b forming a series unit with the thyristor 54a, and surge voltage superimposed on the AC electric path 1 is bypassed by the series unit composed of the thyristor 54a and the second Zener diode 53b. Thus, it is possible to use an FET which forms the step-down circuit 53, whose maximum allowable dissipation is small, and whose outer shape is small. Thus, it is possible to downsize the earth leakage breaker.

Since the cathode of the second Zener diode 53b and the cathode of the thyristor 54a are connected to each other, such that the second Zener diode 53b forms a series unit with the thyristor 54a, the number of components to be used can be reduced, and the earth leakage breaker can be downsized.

Embodiment 3

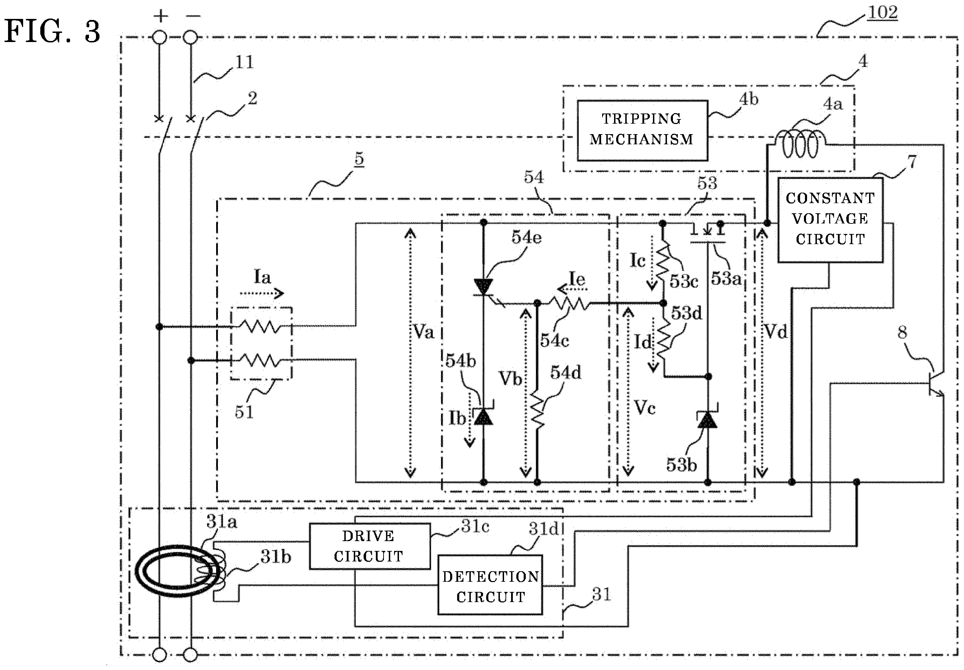

FIG. 3 is a circuit diagram showing a configuration of a DC earth leakage breaker using a power supply circuit in embodiment 3 of the present invention.

In FIG. 3, an earth leakage breaker 102 of the present embodiment is obtained by applying the surge absorption circuit 54 in embodiment 1 to a DC earth leakage breaker. In embodiment 1, the zero-phase current transformer is used as the leakage current detector. However, in the present embodiment, as the leakage current detector, a flux gate sensor 31 capable of detecting DC leakage current is used, and the thyristor 54a is changed to a gate turn-OFF thyristor 54e. The present embodiment also exhibits various effects similar to those in embodiment 1 described above.

As shown in FIG. 3, the flux gate sensor 31 includes: an annular core 31a into which a DC electric path 11 is inserted; a coil 31b wound around the core 31a; a drive circuit 31c for applying, to the coil 31b, voltage by a positive/negative symmetric rectangular wave so as to saturate the density of the magnetic flux of the coil 31b while inverting the direction thereof; and a detection circuit 31d, i.e., an earth leakage detection circuit, for detecting leakage current from measurement voltage which changes in response to coil current flowing in the coil 31b.

The rectification circuit 52 provided in embodiment 1 may be provided for prevention of failure at reverse connection between the positive terminal and the negative terminal. However, for the DC electric path, the rectification circuit 52 is not indispensable and thus omitted, and the step-down circuit 53 and the surge absorption circuit 54 are directly connected to the current limiting circuit 51. Specifically, the anode of the gate turn-OFF thyristor 54e and the drain of the FET 53a are connected to the positive side of the voltage supplied from the DC electric path 11, and the anode of the first Zener diode 54b and the anode of the second Zener diode 53b are connected to the negative side of the voltage supplied from the DC electric path 11.

Not limited thereto, it is sufficient that the gate turn-OFF thyristor 54e is a self-turn-off switching element, and can be formed by a MOSFET, an IGBT, a bipolar transistor, or the like, for example.

The operation of the power supply circuit 5 in the present embodiment is the same as the operation after the DC voltage conversion is performed by the rectification circuit 52 in embodiment 1, and thus, description thereof is omitted.

According to the present embodiment, the earth leakage breaker includes: the flux gate sensor 31 supplied with power by the step-down circuit 53 and for detecting earth leakage of the DC electric path 11; the tripping device 4 supplied with power by the step-down circuit 53 and driven by the flux gate sensor 31 to open the switching contact; the gate turn-OFF thyristor 54e provided in the line on the input side of the step-down circuit 53 and becoming conductive when the input voltage of the step-down circuit 53 reaches a predetermined value; and the first Zener diode 54b provided, with the cathode thereof facing the positive side of the step-down circuit 53, the first Zener diode 54b forming a series unit with the gate turn-OFF thyristor 54e, and surge voltage superimposed on the AC electric path 1 is bypassed by the series unit composed of the gate turn-OFF thyristor 54e and the first Zener diode 54b. Thus, it is possible to use an FET which forms the step-down circuit 53, whose maximum allowable dissipation is small, and whose outer shape is small. Thus, it is possible to downsize the earth leakage breaker.

Embodiment 4

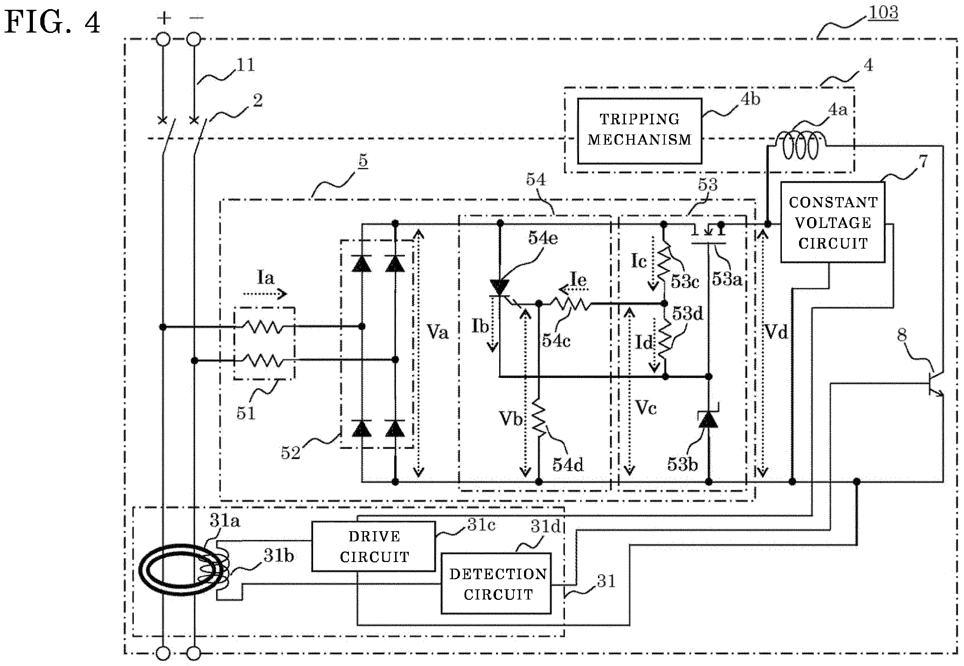

FIG. 4 is a circuit diagram showing a configuration of a DC earth leakage breaker using a power supply circuit in embodiment 4 of the present invention.

In FIG. 4, an earth leakage breaker 103 of the present embodiment is obtained by applying the surge absorption circuit 54 in embodiment 2 to a DC earth leakage breaker. In embodiment 2, the zero-phase current transformer is used as the leakage current detector. However, in the present embodiment, as the leakage current detector, the flux gate sensor 31 capable of detecting DC leakage current is used, and the thyristor 54a is changed to the gate turn-OFF thyristor 54e. The present embodiment also exhibits various effects similar to those in embodiment 2 described above.

In the present embodiment, the rectification circuit 52, which is not provided in embodiment 3, is provided for prevention of failure at reverse connection between the positive terminal and the negative terminal.

As shown in FIG. 4, the flux gate sensor 31 includes: the annular core 31a into which the DC electric path 11 is inserted; the coil 31b wound around the core 31a; the drive circuit 31c for applying, to the coil 31b, voltage by a positive/negative symmetric rectangular wave so as to saturate the density of the magnetic flux of the coil 31b while inverting the direction thereof; and the detection circuit 31d, i.e., an earth leakage detection circuit, for detecting leakage current from measurement voltage which changes in response to coil current flowing in the coil 31b.

The other configurations are the same as those in embodiment 2, and thus, description thereof is omitted.

According to the present embodiment, the earth leakage breaker includes: the flux gate sensor 31 supplied with power by the step-down circuit 53 and for detecting earth leakage of the DC electric path 11; the tripping device 4 supplied with power by the step-down circuit 53 and driven by the flux gate sensor 31 to open the switching contact; the gate turn-OFF thyristor 54e provided in the line on the input side of the step-down circuit 53 and becoming conductive when the input voltage of the step-down circuit 53 reaches a predetermined value; and the second Zener diode 53b provided, with the cathode thereof facing the positive side of the input of the step-down circuit 53, the second Zener diode 53b forming a series unit with the gate turn-OFF thyristor 54e, and surge voltage superimposed on the AC electric path 1 is bypassed by the series unit composed of the gate turn-OFF thyristor 54e and the second Zener diode 53b.

Thus, it is possible to use an FET which forms the step-down circuit 53, whose maximum allowable dissipation is small, and whose outer shape is small. Thus, it is possible to downsize the earth leakage breaker.

Since the cathode of the second Zener diode 53b and the cathode of the gate turn-OFF thyristor 54e are connected to each other, such that the second Zener diode 53b forms a series unit with the gate turn-OFF thyristor 54e, the number of components to be used can be reduced, and the earth leakage breaker can be downsized.

DESCRIPTION OF THE REFERENCE CHARACTERS

| 1 | AC electric path |
| 2 | switching contact |
| 3 | zero-phase current transformer |
| 4 | tripping device |
| 4a | tripping coil |
| 4b | tripping mechanism |
| 5 | power supply circuit |
| 51 | current limiting circuit |
| 52 | rectification circuit |
| 53 | step-down circuit |
| 53a | field-effect transistor (FET) |
| 53b | second Zener diode |
| 54 | surge absorption circuit |
| 54a | thyristor |
| 54b | first Zener diode |
| 6 | earth leakage detection circuit |
| 7 | constant voltage circuit |
| 8 | transistor |
| 100 | earth leakage breaker |

**Claims**

1. An earth leakage breaker comprising:

   a switching contact (2) for switching an electric path;
   a leakage current detector (3) for detecting leakage current of the electric path;
   a step-down circuit (53) for stepping down power supplied from the electric path into power of low voltage;
   an earth leakage detection circuit (6) supplied with power by the step-down circuit (53) and for detecting earth leakage on the basis of a detection signal of the leakage current detector (3);
   a tripping device (4) driven by the earth leakage detection circuit (6) to open the switching contact (2); and
   a surge absorption circuit (54)
   **characterized by**
   the surge absorption circuit being composed of a switching element (54a, 54e) and a first Zener diode (54b) connected in series to the switching element (54a, 54e) such that the anode of the Zener diode (54b) is connected to the negative input terminal of the step-down circuit and the other end of the surge absorption circuit is connected to the positive input terminal of the step-down circuit, the switching element (54a, 54e) comprising a gate connected to a voltage divider circuit such, that the switching element (54a, 54e) becomes conductive, when the input voltage of the step-down circuit (53) reaches a predetermined value.

2. The earth leakage breaker according to claim 1, wherein
   the electric path is a DC electric path (11) and the switching element (54e) is a self-turn-off switching element (54e).

3. The earth leakage breaker according to claim 1, wherein
   the electric path is an AC electric path (1), and the switching element (54a) is a thyristor (54a).

4. The earth leakage breaker according to any one of claims 1 to 3, wherein
   the step-down circuit (53) includes:

a field-effect transistor (53a) whose drain is connected to a positive side of voltage supplied from the electric path;
a series unit composed of a first resistor (53c) and a second resistor (53d) connected between the drain and a gate of the field-effect transistor (53a);
a second Zener diode whose cathode is connected to the gate of the field-effect transistor (53a) and whose anode is connected to a negative side of the electric path;
a third resistor (54c) whose one end is connected to a connection point between the first resistor and the second resistor, and whose other end is connected to a gate of the switching element; and
a fourth resistor (54d) whose one end is connected to the gate of the switching element and whose other end is connected to the negative side of the electric path.

5. The earth leakage breaker according to any one of claims 1 to 3, wherein
the step-down circuit (53) includes:

a field-effect transistor (53a) whose drain is connected to a positive side of voltage supplied from the electric path;
a series unit composed of a first resistor and a second resistor connected between the drain and a gate of the field-effect transistor (53a);
a second Zener diode (53b) whose cathode is connected to the gate of the field-effect transistor (53a) and the switching element and whose anode is connected to a negative side of the electric path;
a third resistor (54c) whose one end is connected to a connection point between the first resistor and the second resistor, and whose other end is connected to a gate of the switching element; and
a fourth resistor (54d) whose one end is connected to the gate of the switching element and whose other end is connected to the negative side of the electric path.

**Patentansprüche**

1. Fehlerstromschutzschalter, der aufweist:

einen Schaltkontakt (2) zum Schalten einer elektrischen Leitung,
einen Fehlerstromdetektor (3) zum Erfassen eines Fehlerstroms auf der elektrischen Leitung,
eine Abwärtswandlerschaltung (53) zum Wandeln der von der elektrischen Leitung zugeführten Leistung in eine Leistung mit herabgesetzter Niederspannung,
eine Fehlerstromerfassungsschaltung (6), die von der Abwärtswandlerschaltung (53) mit Strom versorgt wird und zum Erfassen eines Fehlerstroms auf Basis eines Detektionssignals des Fehlerstromdetektors (3) dient,
eine Auslösevorrichtung (4), die von der Fehlerstromerfassungsschaltung (6) angesteuert wird, um den Schaltkontakt (2) zu öffnen, und
eine Überspannungsabsorptionsschaltung (54),
**dadurch gekennzeichnet, dass**
die Überspannungsabsorptionsschaltung aus einem Schaltelement (54a, 54e) und einer ersten Zenerdiode (54b) aufgebaut ist, die so zu dem Schaltelement (54a, 54e) in Reihe geschaltetet ist, dass die Anode der Zenerdiode (54b) mit dem negativen Eingangsanschluss der Abwärtswandlerschaltung und das andere Ende der Überspannungsabsorptionsschaltung mit dem positiven Eingangsanschluss der Abwärtswandlerschaltung verbunden ist, wobei das Schaltelement (54a, 54e) ein Gate aufweist, das mit einer Spannungsteilerschaltung so verbunden ist, dass das Schaltelement (54a, 54e) leitend wird, wenn die Eingangsspannung der Abwärtswandlerschaltung (53) einen vorgegebenen Wert erreicht.

2. Fehlerstromschutzschalter nach Anspruch 1, wobei
es sich bei der elektrischen Leitung um eine elektrische Gleichstromleitung (11) und bei dem Schaltelement (54e) um ein selbstsperrendes Schaltelement (54e) handelt.

3. Fehlerstromschutzschalter nach Anspruch 1, wobei
es sich bei der elektrischen Leitung um eine elektrische Wechselstromleitung (1) und bei dem Schaltelement (54a) um einen Thyristor (54a) handelt.

4. Fehlerstromschutzschalter nach einem der Ansprüche 1 bis 3, wobei die Abwärtswandlerschaltung (53) aufweist:

einen Feldeffekttransistor (53a), dessen Drain mit einer positiven Seite einer von der elektrischen Leitung zugeführten Spannung verbunden ist,

eine Reihenschaltungseinheit, die aus einem ersten Widerstand (53c) und einem zweiten Widerstand (53d) aufgebaut ist und Drain und Gate des Feldeffekttransistors (53a) verbindet,

eine zweite Zenerdiode, deren Kathode mit dem Gate des Feldeffekttransistors (53a) verbunden ist und deren Anode mit einer negativen Seite der elektrischen Leitung verbunden ist,

einen dritten Widerstand (54c), dessen eines Ende mit einem Verbindungspunkt zwischen dem ersten Widerstand und dem zweiten Widerstand und dessen anderes Ende mit einem Gate des Schaltelements verbunden ist, und

einen vierten Widerstand (54d), dessen eines Ende mit dem Gate des Schaltelements und dessen anderes Ende mit der negativen Seite der elektrischen Leitung verbunden ist.

5. Fehlerstromschutzschalter nach einem der Ansprüche 1 bis 3, wobei die Abwärtswandlerschaltung (53) aufweist:

einen Feldeffekttransistor (53a), dessen Drain mit einer positiven Seite einer von der elektrischen Leitung zugeführten Spannung verbunden ist,

einer Reihenschaltungseinheit, die aus einem ersten Widerstand und einem zweiten Widerstand aufgebaut ist und Drain und Gate des Feldeffekttransistors (53a) verbindet,

eine zweite Zenerdiode (53b), deren Kathode mit dem Gate des Feldeffekttransistors (53a) und dem Schaltelement verbunden ist und deren Anode mit einer negativen Seite der elektrischen Leitung verbunden ist,

einen dritten Widerstand (54c), dessen eines Ende mit einem Verbindungspunkt zwischen dem ersten Widerstand und dem zweiten Widerstand und dessen anderes Ende mit einem Gate des Schaltelements verbunden ist, und

einen vierten Widerstand (54d), dessen eines Ende mit dem Gate des Schaltelements und dessen anderes Ende mit der negativen Seite der elektrischen Leitung verbunden ist.

**Revendications**

1. Disjoncteur de fuite à la terre comprenant:

un contact de commutation (2) pour commuter un chemin électrique;

un détecteur de courant de fuite (3) pour détecter un courant de fuite du chemin électrique;

un circuit abaisseur (53) pour abaisser l'énergie délivrée à partir du chemin électrique en énergie à basse tension;

un circuit de détection de fuite à la terre (6) alimenté en énergie par le circuit abaisseur (53) et pour détecter une fuite à la terre sur la base d'un signal de détection du détecteur de courant de fuite (3);

un dispositif de déclenchement (4) commandé par le circuit de détection de fuite à la terre (6) pour ouvrir le contact de commutation (2); et

un circuit d'absorption de surtension (54)

**caractérisé en ce que**

le circuit d'absorption de surtension est composé d'un élément de commutation (54a, 54e) et d'une première diode Zéner (54b) raccordée en série à l'élément de commutation (54a, 54e) de telle sorte que l'anode de la diode Zéner (54b) soit reliée à la borne d'entrée négative du circuit abaisseur et l'autre extrémité du circuit d'absorption de surtension soit reliée à la borne d'entrée positive du circuit abaisseur, l'élément de commutation (54a, 54e) comprenant une grille reliée à un circuit diviseur de tension de telle sorte que l'élément de commutation (54a, 54e) devienne conducteur, lorsque la tension d'entrée du circuit abaisseur (53) atteint une valeur prédéterminée.

2. Disjoncteur de fuite à la terre selon la revendication 1, dans lequel
le chemin électrique est un chemin électrique de courant continu (11) et l'élément de commutation (54e) est un élément de commutation à arrêt automatique (54e).

3. Disjoncteur de fuite à la terre selon la revendication 1, dans lequel
le chemin électrique est un chemin électrique de courant alternatif (1), et l'élément de commutation (54a) est un thyristor (54a).

4. Disjoncteur de fuite à la terre selon l'une quelconque des revendications 1 à 3, dans lequel
le circuit abaisseur (53) inclut:

un transistor à effet de champ (53a) dont le drain est relié à un côté positif de la tension délivrée à partir du chemin électrique;

une unité série composée d'une première résistance (53c) et d'une deuxième résistance (53d) raccordée entre le drain et une grille du transistor à effet de champ (53a);

une seconde diode Zéner dont la cathode est reliée à la grille du transistor effet de champ (53a) et dont l'anode est reliée à un côté négatif du chemin électrique;

une troisième résistance (54c) dont une extrémité est reliée à un point de branchement entre la première résistance et la deuxième résistance, et dont l'autre extrémité est reliée à une grille de l'élément de commutation; et

une quatrième résistance (54d) dont une extrémité est reliée à la grille de l'élément de commutation et dont l'autre extrémité est reliée au côté négatif du chemin électrique.

5. Disjoncteur de fuite à la terre selon l'une quelconque des revendications 1 à 3, dans lequel le circuit abaisseur (53) inclut:

un transistor à effet de champ (53a) dont le drain est relié à un côté positif de la tension délivrée à partir du chemin électrique;

une unité série composée d'une première résistance et une deuxième résistance raccordée entre le drain et une grille du transistor à effet de champ (53a);

une seconde diode Zéner (53b) dont la cathode est reliée à la grille du transistor effet de champ (53a) et à l'élément de commutation, et dont l'anode est reliée à un côté négatif du chemin électrique;

une troisième résistance (54c) dont une extrémité est reliée à un point de branchement entre la première résistance et la deuxième résistance, et dont l'autre extrémité est reliée à une grille de l'élément de commutation; et

une quatrième résistance (54d) dont une extrémité est reliée à la grille de l'élément de commutation et dont l'autre extrémité est reliée au côté négatif du chemin électrique.

FIG. 1

EP 3 214 634 B1

**FIG. 2**

# FIG. 3

EP 3 214 634 B1

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2051359 A1
- CN 101540249 A
- KR 20130099787 A
- JP H07326278 A
- JP 2009095125 A
- JP 2009195033 A